(19) Europäisches Patentamt
European Patent Office
Office européen des brevets

(11) **EP 2 571 725 B1**

(12) **EUROPÄISCHE PATENTSCHRIFT**

(45) Veröffentlichungstag und Bekanntmachung des Hinweises auf die Patenterteilung:
**28.01.2015 Patentblatt 2015/05**

(21) Anmeldenummer: **11721275.3**

(22) Anmeldetag: **12.05.2011**

(51) Int Cl.:
*G06F 17/50* (2006.01)   *B60Q 1/10* (2006.01)
*G01M 11/06* (2006.01)   *G06K 9/00* (2006.01)

(86) Internationale Anmeldenummer:
**PCT/EP2011/057680**

(87) Internationale Veröffentlichungsnummer:
**WO 2011/144516 (24.11.2011 Gazette 2011/47)**

(54) **VERFAHREN UND STEUERGERÄT ZUM PLAUSIBILISIEREN EINES LEUCHTWEITE-TESTWERTS EINES LICHTKEGELS EINES FAHRZEUGSCHEINWERFERS**

METHOD AND CONTROL UNIT FOR EVALUATING THE PLAUSIBILITY OF AN ILLUMINATING RANGE TEST VALUE OF A LIGHT CONE OF A VEHICLE HEADLAMP

PROCÉDÉ ET CONTRÔLEUR POUR L'ÉVALUATION D'UNE VALEUR DE TEST DE LA PORTÉE DU CÔNE LUMINEUX D'UN PHARE D'AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.05.2010 DE 102010029149**

(43) Veröffentlichungstag der Anmeldung:
**27.03.2013 Patentblatt 2013/13**

(73) Patentinhaber: **Robert Bosch GmbH**
**70442 Stuttgart (DE)**

(72) Erfinder:
• **RENTSCHLER, Tobias**
**75180 Pforzheim (DE)**
• **RENNER, Christian**
**71229 Leonberg (DE)**

(56) Entgegenhaltungen:
**EP-A2- 0 949 118**   **DE-A1- 19 916 175**
**FR-A1- 2 661 248**   **US-A1- 2005 152 581**
**US-A1- 2010 014 713**

## Beschreibung

Stand der Technik

Die vorliegende Erfindung bezieht sich auf ein Verfahren zum Plausibilisieren eines Leuchtweite-Testwerts eines Lichtkegels, ein Verfahren zur Regelung eines Gleitende-Leuchtweite-Systems, ein Steuergerät sowie ein Computerprogrammprodukt gemäß den unabhängigen Ansprüchen.

Systeme zur Detektion von z.B. weißen und/oder gelben Fahrbahnmarkierungen basierend auf monokularen oder Stereovideokameras sind heute in Serie. Das Funktionsprinzip basiert darauf, die Kontrastunterschiede zwischen Fahrbahnbelag und Markierung zu detektieren und daraus die Information der Linien zu erzeugen. Derartige Systeme sind beispielsweise in der DE10311240A1 und der DE102005033641A1 offenbart.

Die Druckschrift DE 199 16 175 A1 offenbart eine Einrichtung zur Einstellung der Leuchtweite eines Fahrzeugsscheinwerfers. Das von der Strasse reflektierte Licht wird von einer optoelektronischen Sensoreinrichtung erfasst und einen Punkt des Reflexionsintensitätsmaximums wird ermittelt. Anhand dieser Messung wird die Leuchtweite geregelt. Die Einstellung der Richtung des Lichtsbündels wird auf Plausibilität überprüft.

Offenbarung der Erfindung

Vor diesem Hintergrund wird mit der vorliegenden Erfindung ein Verfahren zum Plausibilisieren eines Leuchtweite-Testwerts eines Lichtkegels mindestens eines Scheinwerfers eines Fahrzeugs, ein Verfahren zur Regelung eines Gleitende-Leuchtweite-Systems des Fahrzeugs, weiterhin ein Steuergerät, das diese Verfahren verwendet sowie schließlich ein entsprechendes Computerprogrammprodukt gemäß den unabhängigen Patentansprüchen vorgestellt. Vorteilhafte Ausgestaltungen ergeben sich aus den jeweiligen Unteransprüchen und der nachfolgenden Beschreibung.

Die vorliegende Erfindung schafft ein Verfahren zum Plausibilisieren eines Leuchtweite-Testwerts eines Lichtkegels mindestens eines Scheinwerfers eines Fahrzeugs, wobei das Verfahren die folgenden Schritte aufweist: Einlesen einer Reflexionsintensität eines Punktes auf mindestens einer von dem Lichtkegel beleuchteten Fahrbahnmarkierung; Erstellen eines Reflexionsintensitätsmodells für die Fahrbahnmarkierung, basierend auf der eingelesenen Reflexionsintensität und einer bestimmten Entfernung des Punktes von dem Fahrzeug, wobei das Reflexionsintensitätsmodell ausgebildet ist, um unterschiedlichen Positionen auf der Fahrbahnmarkierung vor dem Fahrzeug unterschiedliche Reflexionsintensitäten zuzuordnen; Bestimmen eines Leuchtweite-Plausibilitätswerts, bei dem gemäß dem Reflexionsintensitätsmodell eine Reflexionsintensität auf der Fahrbahnmarkierung erreicht ist, die einem Reflexionsintensitätsschwellwert entspricht; und Vergleichen des Leuchtweite-Plausibilitätswerts mit dem Leuchtweite-Testwert, um den Leuchtweite-Testwert zu plausibilisieren, insbesondere um den Leuchtweite-Testwert dann zu plausibilisieren, wenn der Leuchtweite-Plausibilitätswert innerhalb eines Toleranzbereiches um den Leuchtweite-Testwert liegt.

Auch schafft die vorliegende Erfindung eine Vorrichtung zum Plausibilisieren eines Leuchtweite-Testwerts eines Lichtkegels mindestens eines Scheinwerfers eines Fahrzeugs, wobei das Verfahren die folgenden Schritte aufweist: eine Einheit zum Einlesen einer Reflexionsintensität eines Punktes auf mindestens einer von dem Lichtkegel beleuchteten Fahrbahnmarkierung; eine Einheit zum Erstellen eines Reflexionsintensitätsmodells für die Fahrbahnmarkierung, basierend auf der eingelesenen Reflexionsintensität und einer bestimmten Entfernung des Punktes von dem Fahrzeug, wobei das Reflexionsintensitätsmodell ausgebildet ist, um unterschiedlichen Positionen auf der Fahrbahnmarkierung vor dem Fahrzeug unterschiedliche Reflexionsintensitäten zuzuordnen; eine Einheit zum Bestimmen eines Leuchtweite-Plausibilitätswerts, bei dem gemäß dem Reflexionsintensitätsmodell eine Reflexionsintensität erreicht ist, die einem Reflexionsintensitätsschwellwert entspricht; und eine Einheit zum Vergleichen des Leuchtweite-Plausibilitätswerts mit dem Leuchtweite-Testwert, um den Leuchtweite-Testwert zu plausibilisieren, insbesondere um den Leuchtweite-Testwert dann zu plausibilisieren, wenn der Leuchtweite-Plausibilitätswert innerhalb eines Toleranzbereiches um den Leuchtweite-Testwert liegt.

Mit dem hier vorgestellten Verfahren kann beispielsweise überprüft werden, ob auf nächtlicher Straße andere Verkehrsteilnehmer durch die Scheinwerfer des eigenen Fahrzeugs geblendet werden. Das Plausibilisieren kann beispielsweise durch einen Vergleich des Leuchtweite-Testwerts mit einem weiteren Wert erfolgen, um zu überprüfen, ob basierend auf dem Leuchtweite-Testwert zum Beispiel der Lichtkegel des mindestens einen Scheinwerfers so eingestellt ist, dass zum einen weder ein vorausfahrendes und/oder ein entgegenkommendes Fahrzeug geblendet wird und zum anderen ein größtmöglicher Teil einer Fahrzeugumgebung von dem Lichtkegel beleuchtet wird. Der Leuchtweite-Testwert kann beispielsweise mit einem Gleitende-Leuchtweite-System des Fahrzeugs bestimmt und als eine Entfernung in Metern von dem Fahrzeug angegeben werden. Der Leuchtweite-Testwert stellt somit einen Abstandswert dar, der von einem System gemessen oder bereitgestellt wird, das vom hier beschriebenen System zur Plausibilisierung unabhängig ist. Der Leuchtweite-Testwert kann beispielsweise einen Abstand eines vorausfahrenden Fahrzeugs bezeichnen, der von einem Abstandsmesssystem beispielsweise an Hand von erkannten Rücklichtern des vorausfahrenden Fahrzeugs bestimmt wird. Das Plausibilisieren kann beispielsweise mittels eines speziellen Algorithmus durchgeführt werden. Der Leuchtweite-Testwert kann z.B. eine Endkante des Lichtkegels repräsentieren und zum Beispiel über eine Neigung der Fahrzeugscheinwerfer verändert werden. Der Lichtkegel kann zum Beispiel von beiden Frontscheinwerfern des Fahrzeugs gebildet werden und eine vor dem Fahrzeug liegende Straße sowie einen Teil einer Fahrzeugumgebung beleuchten. Das Erfassen kann beispielsweise optisch über eine Kamera oder einen Sensor des Fahrzeugs erfolgen. Die Reflexionsintensität kann z.B. beschreiben, in welcher Stärke das Licht der Scheinwerfer auf die Erfassungseinheit zurückgeworfen wird und kann zum Beispiel in Lux angegeben werden. Der reflektierende Punkt auf der Fahrbahnmarkierung kann beispielsweise durch einen Quarzkörnchen oder ein sonstiges Element, das Bestandteil der Fahrbahnmarkierung ist, verursacht werden. Bei der Fahrbahnmarkierung kann es sich um eine der weißen oder gelben durchgezogenen beziehungsweise unterbrochenen Linien am Rand und/oder in der Mitte einer Straße handeln, die die Fahrbahnen für die Fahrzeuge festlegen.

Unter einer Reflexionsintensität kann somit beispielsweise eine Lichtstärke verstanden werden, die nach der Beleuchtung mittels eines Scheinwerfers von einer bestimmten Position der Fahrbahnmarkierung mittels eines optischen Detektors wie beispielsweise eine Kamera erfasst oder eingelesen wird. Das Reflexionsintensitätsmodell kann ein mathematisches Modell sein, das mittels einer Interpolierung der Mehrzahl von Punkten einen Graph abbildet, der jedem Punkt auf der von dem Lichtkegel erfassten Fahrbahnmarkierung eine entsprechende Reflexionsintensität und eine entsprechende Entfernung von dem Fahrzeug zuordnet. Der Graph kann beispielsweise die Form einer Parabel zweiter oder höherer Ordnung aufweisen. Insbesondere kann das Reflexionsintensitätsmodell eine konkrete Funktion aus einer Funktionenschaar repräsentieren, die unter Verwendung der eingelesenen Reflexionsintensität des Punktes bestimmt wird. Somit kann durch das Reflexionsmodell unterschiedlichen Positionen auf der Fahrbahnmarkierung vor dem Fahrzeug unterschiedliche Reflexionsintensitäten zugeordnet werden. Die unterschiedlichen Positionen können durch unterschiedliche Punkte auf der Fahrbahnmarkierung repräsentiert sein, die einen jeweils anderen d.h. unterschiedlichen Abstand vom Fahrzeug haben. Der Leuchtweite-Plausibilitätswert kann anhand des Reflexionsintensitätsmodells bestimmt werden und wie der Leuchtweite-Testwert ebenfalls in Metern Entfernung von dem Fahrzeug ausgedrückt werden. Der Leuchtweite-Plausibilitätswert repräsentiert dabei zum Beispiel ebenfalls einen Abstandswert, der einem Abstand vor dem Fahrzeug entspricht, bei dem die Lichtintensität gemäß dem Reflexionsmodell dem Reflexionsschwellwert entspricht. Der Reflexionsintensitätsschwellwert kann einen bestimmten Leucht- oder Lichtintensitätswert repräsentieren und vorgegeben sein, beispielsweise durch einen in dem Fahrzeug verwendeten Scheinwerfertyp, und kann mathematisch zum Beispiel durch eine Schnittebene oder eine Gerade durch den Graph des Reflexionsintensitätsmodells abgebildet werden. Dabei kann beispielsweise ein Schnittpunkt der Schnittebene mit dem Graph dem Reflexionsintensitätsschwellwert entsprechen. Der Schritt des Vergleiches kann beispielsweise mittels eines geeigneten Algorithmus erfolgen. Der Toleranzbereich um den Leuchtweite-Testwert kann ein Bereich um den Leuchtweite-Testwert repräsentieren, der konfigurierbare und/oder parameterisierbare Grenzen aufweist.

Die Erfindung basiert insbesondere auf einer Detektion einer Stärke von Lichtreflexionen auf Fahrbahnmarkierungen, die z.B. von den Frontscheinwerfern eines Fahrzeugs angestrahlt werden. Kombiniert man diese Linienintensitätsmessung mit einem mathematischen Reflexionsmodell, so kann eine Entfernung einer Ausleuchtung vom Fahrzeug bis zum Ende des Leuchtkegels bestimmt werden.

Ein weiterer Aspekt der Erfindung ist eine Nutzung dieser Information zur Plausibilisierung einer aktuellen Regelgüte einer gleitenden Leuchtweite (GLW-Regelgüte).

Gemäß dem hier vorgestellten Ansatz kann insbesondere eine Ausleuchtungssicherheit eines geregelten Lichtes verbessert werden. Bei GLW-Funktionen (GLW = gleitende Leuchtweite) ist es wichtig, sicherzustellen, dass unter allen Umständen durch die Ausleuchtung keine anderen Verkehrsteilnehmer, z.B. ein einem vorausfahrenden Fahrzeug, geblendet werden. Deshalb sind herkömmliche GLW-Systeme sehr konservativ ausgelegt. Mit dem hier dargelegten Ansatz können GLW-Systeme erheblich sicherer ausgelegt werden, was zu deutlich besseren Ausleuchtverhältnissen führen kann. Ein zusätzlicher Aspekt des erfindungsgemäßen Ansatzes besteht somit darin, die Ausleuchtweite über ein zweites unabhängiges Merkmal, die Linienreflexionen, gegenzuplausibilisieren und dadurch die Ausleuchtentfernung zu verifizieren.

Gemäß einer Ausführungsform kann der Leuchtweite-Testwert basierend auf einer Erfassung eines in dem Lichtkegel befindlichen Objekts bestimmt werden. Bei dem Objekt kann es sich beispielsweise um ein vorausfahrendes Fahrzeug oder ein entgegenkommendes Fahrzeug handeln. Der Leuchtweite-Testwert kann beispielsweise basierend auf einer Erkennung der Stoßstange oder Rücklichter des vorausfahrenden oder entgegenkommenden Fahrzeugs bestimmt werden. Die Erfassung kann zum Beispiel mittels einer Kamera des Fahrzeugs erfolgen.

Ferner kann in dem Schritt des Einlesens die Reflexionsintensität an dem Punkt auf der Fahrbahnmarkierung eingelesen werden, an dem die Reflexionsintensität, betrachtet über alle Punkte auf der Fahrbahnmarkierung, maximal ist. Dadurch ist der Vorteil gegeben, dass die auf dem Reflexionsintensitätsmodell basierende Wertermittlung zur Plausibilisierung des Leuchtweite-Testwerts robuster ausgestaltet werden kann.

Weiterhin kann in dem Schritt des Einlesens die Reflexionsintensität eines Punktes eingelesen werden, der auf der längsten aus einer Mehrzahl von vom Lichtkegel beleuchteten Fahrbahnmarkierungen liegt. Die Verwendung der längsten Fahrbahnmarkierung bietet den Vorteil, dass basierend auf dem Reflexionsintensitätsmodell eine größere Bandbreite von Reflexionsintensitätswerten mit einer feineren Inkrementierung zur Verfügung stehen kann, so dass der Leuchtweite-Plausibilitätswert wesentlich genauer definiert und entsprechend die Plausibilisierung des Leuchtweite-Testwerts so genau durchgeführt werden kann, dass selbst geringste Abweichungen detektiert werden können.

Gemäß einer Ausführungsform kann in dem Schritt des Bestimmens ein Reflexionsintensitätsschwellwert verwendet werden, der von einem in dem Fahrzeug verwendeten Scheinwerfertyp abhängig ist. So ist das hier vorgeschlagene Verfahren vorteilhafterweise vielseitig einsetzbar, da es ohne weiteres an verschiedenste handelsübliche Scheinwerfertypen angepasst werden kann. Die Scheinwerfertypen sind ferner bei der Implementierung des Verfahrens in dem konkreten Fahrzeug bekannt.

Die vorliegende Erfindung schafft ferner ein Verfahren zur Regelung eines Gleitende-Leuchtweite-Systems des Fahrzeugs, wobei das Verfahren die folgenden Schritte aufweist: die Schritte gemäß einem der vorangegangenen Ansprüche, um einen plausibilisierten Leuchtweite-Testwert zu erhalten; und Regeln des Gleitende-Leuchtweite-Systems basierend auf dem plausibilisierten Leuchtweite-Testwert.

Das Gleitende-Leuchtweite-System, kurz GLW-System, kann beispielsweise ein intelligenter Lichtassistent eines Fahrzeugs sein, der dazu dienen kann, die Leuchtweite der Fahrzeugscheinwerfer so zu regeln, dass sie stufenlos an eine durch vorausfahrende und/oder entgegenkommende Fahrzeuge bedingte Verkehrslage angepasst werden kann. Dies kann z.B. geschehen, indem das System einen Leuchtweite-Testwert ermittelt und bereitstellt, der z.B. auf einer Erkennung einer Stoßstange und/oder von Rücklichtern bzw. Scheinwerfern der anderen Fahrzeuge basiert. Unter Verwendung des Leuchtweite-Testwerts kann beispielsweise eine Neigung der Fahrzeugscheinwerfer so eingestellt werden, dass Insassen der vorausfahrenden und/oder entgegenkommenden Fahrzeuge nicht geblendet werden. Die Regelung kann zum Beispiel mittels einer Regelschleife unter Verwendung eines geeigneten Algorithmus erfolgen. Das im Vorhergehenden beschriebene Verfahren zum Plausibilisieren eines Leuchtweite-Testwerts und die Regelung des GLW-Systems können unter Verwendung derselben oder unterschiedlicher Komponenten, z.B. Kameras und/oder Steuergeräte, des Fahrzeugs durchgeführt werden.

Die vorliegende Erfindung schafft ferner ein Steuergerät, das ausgebildet ist, um die Schritte des erfindungsgemäßen Verfahrens durchzuführen bzw. umzusetzen. Insbesondere kann das Steuergerät Einrichtungen aufweisen, die ausgebildet sind, um je einen Schritt des Verfahrens auszuführen. Auch durch diese Ausführungsvariante der Erfindung in Form eines Steuergeräts kann die der Erfindung zugrunde liegende Aufgabe schnell und effizient gelöst werden.

Unter einem Steuergerät oder einer Vorrichtung kann vorliegend ein elektrisches Gerät verstanden werden, das Sensorsignale verarbeitet und in Abhängigkeit davon Steuersignale ausgibt. Das Steuergerät kann eine Schnittstelle aufweisen, die hard- und/oder softwaremäßig ausgebildet sein kann. Bei einer hardwaremä-ßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert ist und zur Durchführung des Verfahrens nach einem der vorstehend beschriebenen Ausführungsformen verwendet wird, wenn das Programm auf einem Steuergerät oder einer Vorrichtung ausgeführt wird.

Die Erfindung wird anhand der beigefügten Zeichnungen beispielhaft näher erläutert. Es zeigen:

Fig. 1    ein Ablaufdiagramm eines Verfahrens zum Plausibilisieren eines Leuchtweite-Testwerts, gemäß einem Ausführungsbeispiel der vorliegenden Erfindung;

Fig. 2    eine Darstellung von Komponenten eines Systems zum Plausibilisieren eines Leuchtweite-Testwerts eines GLW-Systems, gemäß einem Ausführungsbeispiel der vorliegenden Erfindung;

Fig. 3    eine Darstellung von Reflexionen von Fahrspurmarkierungen in einer Anzeige;

Fig. 4    eine Darstellung eines Reflexionsintensitätsmodells in einem Koordinatensystem, gemäß einem Ausführungsbeispiel der vorliegenden Erfindung; und

Fig. 5    Darstellungen eines Lichtintensitätsverlaufs gemäß dem erstellten Reflexionsintensitätsmodell sowie einer Leuchtweite der Scheinwerfer auf einer Fahrbahn mittels eines weiteren Koordinatensystems, gemäß einem Ausführungsbeispiel der vorliegenden Erfindung.

Gleiche oder ähnliche Elemente können in den Figuren durch gleiche oder ähnliche Bezugszeichen versehen sein, wobei auf eine wiederholte Beschreibung verzichtet wird. Ferner enthalten die Figuren der Zeichnungen, deren Beschreibung sowie die Ansprüche zahlreiche Merkmale in Kombination. Einem Fachmann ist dabei klar, dass diese Merkmale auch einzeln betrachtet werden oder sie zu weiteren, hier nicht explizit beschriebenen Kombinationen zusammengefasst werden können. Weiterhin ist die Erfindung in der nachfolgenden Beschreibung unter Verwendung von unterschiedlichen Maßen und Dimensionen erläutert, wobei die Erfindung nicht auf diese Maße und Dimensionen eingeschränkt zu verstehen ist. Ferner können erfindungsgemäße Verfahrensschritte wiederholt sowie in einer anderen als in der beschriebenen Reihenfolge ausgeführt werden. Umfasst ein Ausführungsbeispiel eine "und/oder" Verknüpfung zwischen einem ersten Merkmal/Schritt und einem zweiten Merkmal/Schritt, so kann dies so gelesen werden, dass das Ausführungsbeispiel gemäß einer Ausführungsform sowohl das erste Merkmal / den ersten Schritt als auch das zweite Merkmal /den zweiten Schritt und gemäß einer weiteren Ausführungsform entweder nur das erste Merkmal /Schritt oder nur das zweite Merkmal /Schritt aufweist.

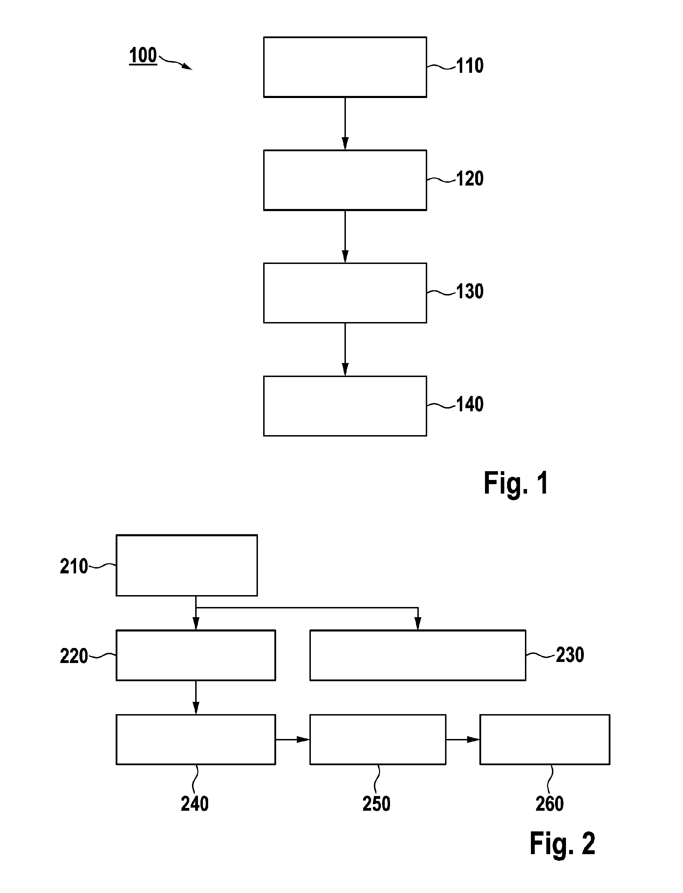

Fig. 1 zeigt ein Ablaufdiagramm eines Verfahrens 100 zur Plausibilisierung einer Lichtkegelleuchtweite bzw. eines Leuchtweite-Testwerts eines Lichtkegels von Fahrzeugscheinwerfern auf der Basis einer Reflexionsstärke von Fahrspurmarkierungen. Dabei kann der Leuchtweite-Testwert beispielsweise mit einem GLW-System eines Fahrzeugs ermittelt worden sein. In einem Schritt des Einlesens 110 wird eine Reflexionsintensität eines Punktes auf einer von einem oder zwei Scheinwerfern des Fahrzeugs beleuchteten Fahrbahnmarkierung erfasst oder eingelesen. Beispielsweise kann die reflektierende Fahrbahnmarkierung von einer Kamera des Fahrzeugs aufgenommen werden. Über einen geeigneten Algorithmus kann dann aus dem Kamerabild ein Reflexionsintensitätswert des Punktes ermittelt und z.B. in Lux angegeben werden. Der Reflexionsintensitätswert dieses Punktes und eine gemessene Entfernung des Punktes von dem Fahrzeug können dann in einem auf den Schritt des Einlesens folgenden Schritt des Erstellens 120 verwendet werden, um in diesem Schritt 120 ein mathematisches Reflexionsintensitätsmodell für den gesamten beleuchteten Bereich der Fahrbahnmarkierung zu erstellen. Das Reflexionsintensitätsmodell kann ausgebildet sein, um z.B. jedem Punkt auf dem beleuchteten Bereich der Fahrbahnmarkierung eine entsprechende Entfernung von dem Fahrzeug zuzuordnen. Das Reflexionsintensitätsmodell wird in einem auf den Schritt des Erstellens 120 folgenden Schritt des Bestimmens 130 verwendet, um einen Leuchtweite-Plausibilitätswert zu bestimmen, basierend auf einer Reflexionsintensität auf der Fahrbahnmarkierung, die einem Reflexionsintensitätsschwellwert entspricht. Der Reflexionsintensitätsschwellwert kann dabei vorgegeben oder variabel sein. In einem auf den Schritt des Bestimmens 130 folgenden Schritt des Vergleichens 140 schließlich wird der Leuchtweite-Plausibilitätswert mit dem Leuchtweite-Testwert verglichen, um diesen zu plausibilisieren. Insbesondere kann der Leuchtweite-Testwert plausibilisiert werden, wenn der Leuchtweite-Plausibilitätswert innerhalb eines Toleranzbereiches um den Leuchtweite-Testwert liegt. So kann beispielsweise verifiziert werden, dass der Lichtkegel zum einen nicht zu weit vor das Fahrzeug reicht, wodurch andere Verkehrsteilnehmer geblendet werden könnten, und zum anderen einen nicht zu kleinen Bereich vor dem Fahrzeug ausleuchtet, wodurch eine Sichtweite eines Fahrers des Fahrzeugs unnötig eingeschränkt wäre.

Fig. 2 zeigt eine Darstellung von Komponenten eines Systems zum Plausibilisieren eines Leuchtweite-Testwerts eines GLW-Systems, gemäß einem Ausführungsbeispiel der vorliegenden Erfindung. Ein derartiges System kann beispielsweise in einem Fahrzeug während einer Nachtfahrt zum Einsatz kommen. Gezeigt sind eine Videokamera 210, ein Linienerkennungsmodul 220, ein Scheinwerfererkennungsmodul 230, ein Reflexionsintensitätsmodell 240, ein GLW-Regler 250 sowie ein oder mehrere Scheinwerfer 260. Gemäß der Darstellung in Fig. 2 übermittelt die Videokamera 210 erfasste Informationen über die Fahrzeugumgebung über eine geeignete Schnittstelle an das Linienerkennungsmodul 220 sowie das Scheinwerfererkennungsmodul 230. Die Informationen können beispielsweise eine oder mehrere von den Scheinwerfern des Fahrzeugs beleuchtete Fahrbahnmarkierungen und/oder Scheinwerfer eines entgegenkommenden Fahrzeugs betreffen. Die Informationen bezüglich der Fahrbahnmarkierung(en) werden in dem Linienerkennungsmodul 220 unter anderem im Hinblick auf eine Reflexionsintensität zum Beispiel eines Punktes auf der (oder einer erkannten längsten) Fahrbahnmarkierung so aufbereitet, dass sie zur Erstellung des Reflexionsintensitätsmodells 240 verwendet werden können. In dem Scheinwerfererkennungsmodul 230 werden die Informationen über die erfassten Scheinwerfer eines Fremdfahrzeugs beispielsweise in Bezug auf eine Entfernung des Fremdfahrzeugs ausgewertet und über eine geeignete Schnittstelle an den GLW-Regler 250 ausgegeben. Der GLW-Regler 250 bestimmt, basierend auf den empfangenen Informationen, zum Beispiel einen Leuchtweite-Testwert, über den beispielsweise eine Neigung des oder der Scheinwerfer 260 so eingestellt wird, dass ein anderer Verkehrsteilnehmer nicht geblendet wird. Ein mithilfe des Reflexionsintensitätsmodells 240 ermittelter Plausibilitätswert für den Leuchtweite-Testwert wird dem GLW-Regler 250, beispielsweise über eine weitere geeignete Schnittstelle, übermittelt und dort mit dem Leuchtweite-Testwert verglichen, so dass zum Beispiel die Scheinwerferneigung, basierend auf einem Ergebnis des Vergleichs, beibehalten oder angepasst wird .

Das System gemäß dem in Fig. 2 gezeigten Ausführungsbeispiel besteht aus der Kombination der gemessenen Reflexionsstärke der Fahrbahnmarkierungen und der GLW-Plausibilisierung für die GLW-Regelgüte bzw. den Leuchtweite-Testwert. Wie bereits beschrieben, besteht das in Fig. 2 dargestellte System aus den vorstehend beschriebenen Komponenten. Die Videokamera 210 nimmt das Bild der Umgebung vor dem Fahrzeug auf. Ein Algorithmus zur Linienerkennung 220 detektiert die einzelnen Linien. Ein zweiter Algorithmus zur Scheinwerfererkennung 230 detektiert die Front- und/oder Rücklichter von anderen Fahrzeugen. Auf Basis der Front- und/oder Rücklichter regelt der GLW-Regler 250 den Scheinwerferlichtkegel z.B. bis unter die Unterkante des vorausfahrenden Fahrzeuges. Die Linienerkennung 220 und die GLW-Funktion 250 können auf ein und denselben oder aber auf getrennten Kameras bzw. Steuergeräten ablaufen. Das basierend auf der Linienerkennung 220 erstellte Linienintensitätsmodell beziehungsweise Reflexionsintensitätsmodell mit dem Grad n 240 kann z.B. die Form einer Parabel (n=2) aufweisen und gemäß folgender Gleichung (1) bestimmt werden:

$$I(x) = -(x - x_0)^n + I_{max} \qquad (1)$$

Dabei gilt:

$x$ = longitudinaler Abstand vom Fahrzeug (der Koordinatensystemursprung ist im Fahrzeug verortet)
$I$ = Intensität der Linienreflexion der Fahrbahnmarkierung(en)
$I_{max}$ = maximale Intensität auf der Linie oder längsten Linie
$x_0$ = Abstand, an der die maximale Intensität auf der Linie gemessen wird
$n$ = Modellordnung, wobei nur gerade Zahlen n = 2, 4, 6, 8, ... sinnvoll sind

Die Annahme des Parabelmodells entspricht der Näherung der Ausleuchtung eines Scheinwerferkegels und kann in der Ordnung n noch variiert werden.

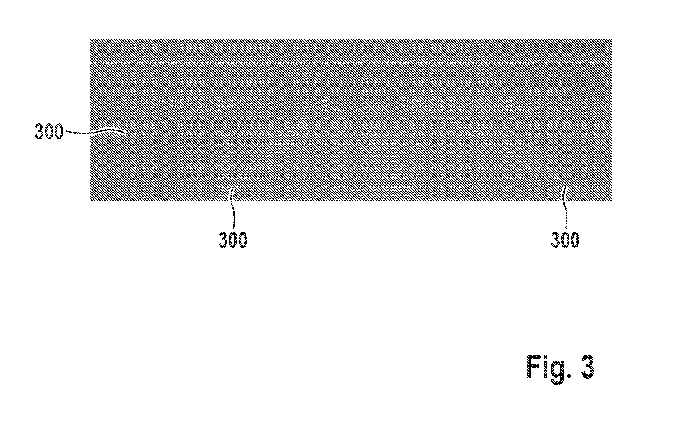

Fig. 3 zeigt eine Darstellung von aus einem Videobild erkannten Linien 300. Es kann sich bei den Linien 300 z.B. um Reflexionen von Fahrspurmarkierungen auf einer Straße handeln. Eine Reflexionsintensität der Fahrbahnmarkierungen 300 kann über eine Länge derselben variieren, unter anderem in Abhängigkeit von einer Entfernung eines bestimmten Punktes auf den Fahrbahnmarkierungen 300 von dem Fahrzeug.

Aus dem in Fig. 3 gezeigten Bild wird gemäß der modellbasierten Leuchtweitenbestimmung die Reflexionsstärke aller im Bild vorkommender Linien bzw. Fahrbahnmarkierungen 300 extrahiert. Auf Basis der längsten Linie im Bild wird ein Reflexionsintensitätsmodell bestimmt. Es wird über den Abstand vom Fahrzeug bis zum Ende der Linie 300 die Stärke der Reflexionen, also eine Intensität eines Grauwerts, gemessen. Um eine hohe Robustheit der gemessenen Leuchtweite zu erreichen, wird nur der maximale Wert der Intensität auf der Linie 300 ermittelt. Es können diverse mathematische Modelle verwendet werden, die die Ausleuchtcharakteristik der Scheinwerfer abbilden.

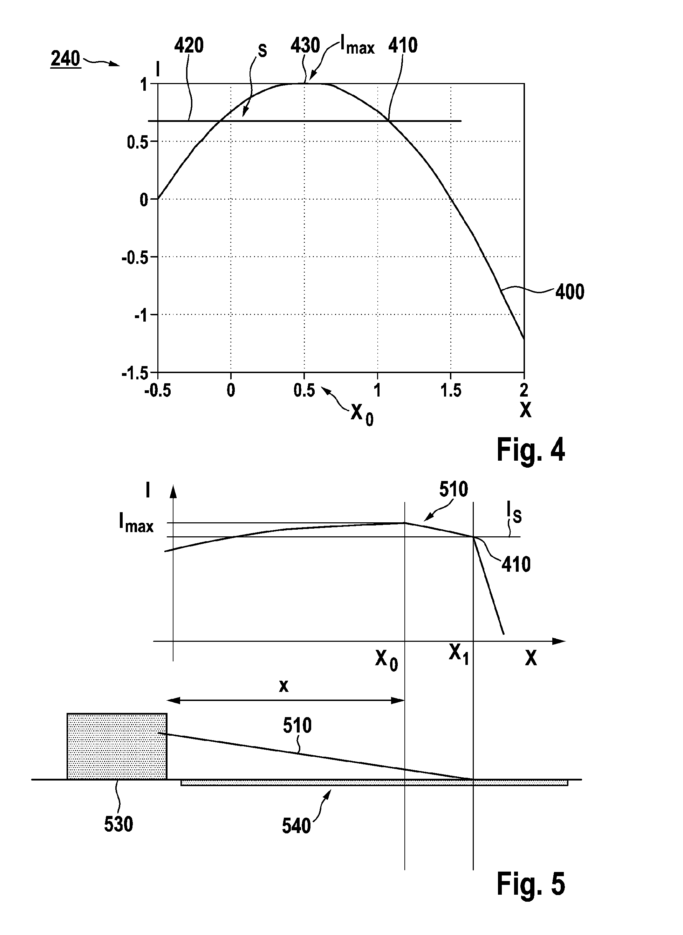

Fig. 4 zeigt eine Darstellung eines parabelförmigen Kurvenverlaufes für das Reflexionsintensitätsmodell 240 gemäß der im Vorhergehenden erläuterten Gleichung (1) in einem Koordinatensystem, gemäß einem Ausführungsbeispiel der vorliegenden Erfindung. Gezeigt sind ein Funktionsgraph 400 in Form einer Parabel sowie eine Schnittebene $I_S$ 420 in einem Koordinatensystem. Auf der Abszisse ist der longitudinale Abstand x vom Fahrzeug, zum Beispiel in Metern, aufgetragen. Auf der Ordinate ist die Reflexionsintensität I aufgetragen. Hier kann als Einheit beispielsweise Lux verwendet werden. Bei dem in Fig. 4 gezeigten Koordinatensystem sind auf der Abszisse Werte von -0,5 bis 2 aufgetragen und auf der Ordinate Werte von -1,5 bis 1 aufgetragen. Der Funktionsgraph 400 bildet eine Veränderung der Lichtintensität beziehungsweise Reflexionsintensität I auf einer Fahrbahnmarkierung in Abhängigkeit von einer Entfernung x von dem Fahrzeug ab. Der Scheitel der Parabel 400 (d.h. des Funktionsgraphs) bei $x_0$ 430 markiert die maximale Reflexionsintensität $I_{max}$ auf der beleuchteten Fahrbahnmarkierung. Die Schnittebene $I_S$ verläuft parallel zur Abszisse und schneidet den Graphen 400 auf einer Höhe eines Werts von etwa 0,6 auf der Ordinate. Das hier dargestellte Reflexionsintensitätsmodell wird bestimmt, indem $I_{max}$ und $x_0$ gemessen werden und n gewählt wird. n wird vorliegend mit einem Wert von 2 angenommen. Ein Schnittpunkt der Schnittebene $I_S$ 420 mit dem Funktionsgraphen 400 markiert einen Reflexionsintensitätsschwellwert 410. Über diesen kann der longitudinale Abstand x ermittelt werden, bis zu dem die Scheinwerferausleuchtung reicht. Man erhält die modellbasierte Linienausleuchtweite. Die Schnittebene $I_S$ kann, zum Beispiel in Abhängigkeit von einem in dem Fahrzeug verwendeten Scheinwerfertyp, variabel sein und die Funktion 400 an anderer Stelle schneiden. Entsprechend ändert sich eine Position des Schnittpunkts 410 mit dem Ergebnis einer veränderten Linienausleuchtweite.

Fig. 5 zeigt mittels eines anderen Koordinatensystems einen Lichtintensitätsverlauf 510 sowie eine Leuchtweite 520 der Scheinwerfer 260 eines Fahrzeugs 530 auf einer Fahrbahn, gemäß einem Ausführungsbeispiel der vorliegenden Erfindung. Wiederum ist auf der Abszisse des in Fig. 5 oben dargestellten Teildiagramms der longitudinale Abstand x vom Fahrzeug und auf der Ordinate die Reflexionsintensität I aufgetragen. Das Koordinatensystem bildet die Schnittebene $I_S$ sowie die Lichtintensitätsverlaufsfunktion 510 ab, die einen Lichtintensitätsverlauf beziehungsweise Reflexionsintensitätsverlauf gemäß dem bereits im Zusammenhang mit Figuren 2 und 4 erläuterten Reflexionsintensitätsmodell 240 repräsentiert. Weiterhin sind in Fig. 5 in der unteren Darstellung der Pkw beziehungsweise Fahrzeug 530, eine Linie bzw. Fahrbahnmarkierung 540 und eine Gerade abgebildet, die die Leuchtweite 520 der Scheinwerfer 260 des Fahrzeugs 530 repräsentiert. Bei $x_0$ schneidet eine Senkrechte die Funktion 510 und die Leuchtweite 520 und kennzeichnet den Punkt $I_{max}$ auf der Fahrbahnmarkierung 540. Eine weitere Senkrechte markiert den Reflexionsintensitätsschwellwert 410 auf der Funktion 510, an dem die Schnittebene $I_S$ die Funktion 510 schneidet und ab dem die Reflexionsintensität I mit zunehmendem Abstand zum Fahrzeug 530 stark gegen Null strebt. Ein Schnittpunkt der weiteren Senkrechen mit der Abszisse definiert somit einen Leuchtweite-Plausibilitätswert $x_1$ der modellbasierten Linienausleuchtweite. Dieser kann gegebenenfalls für eine Plausibilisierung der GLW-Regelgüte bzw. GLW-Linienausleuchtfunktion in der GLW-Regelung (beispielsweise im GLW-Regler 550) benutzt werden. Eine einfache Plausibilisierung kann erfolgen, indem die eingeregelte Leuchtweite 520 mit der modellbasierten Linienausleuchtweite verglichen wird. So können Messfehler in der GLW-Objektausleuchtweite korrigiert werden. Liegt keine Objektinformation vor, so kann die Linieninformation als Ersatz benutzt werden.

Eine sinnvolle Erweiterung heutiger Lichtfunktionen ist ein Einbau zusätzlicher regelbarer Frontscheinwerfer-Lichter, die nur eine Ausleuchtung der vorausliegenden Linien vornehmen. In so einem System würde die modellbasierte Linienausleuchtweite 520 als Istgröße der aktuellen Linienausleuchtung dienen und in dem eigenen GLW-Linienregler eingesetzt werden. Diese Zusatzscheinwerfer können laterale kleine Abstrahlwinkel besitzen, da sie nur auf die Fahrbahnmarkierungen der eigenen Fahrspur ausgerichtet werden und den Seitenbereich nicht ausleuchten müssen.

Gemäß dem hier vorgestellten Ansatz kann die optimale Leuchtweite mittels der Reflexionen auf der Fahrspurmarkierung ermittelt werden. Dieser ist damit unabhängig von einer Existenz wie auch immer gearteter Objekte mit gegebenenfalls unbekannten Reflexionseigenschaften sowie verschiedenen Fahrbahnuntergründen mit unterschiedlichen Reflexionseigenschaften. Die Fahrbahnmarkierungen eignen sich insbesondere, um mittels eines mathematischen Reflexionsmodells definiert die Leuchtweite zu bestimmen. Somit wird erfinderisch eine Lücke geschlossen zwischen der Idee, mittels Messung der Reflexion Wissen über die Leuchtreichweite zu erlangen, und einer konkreten Realisierungsvariante, z.B. über einen Algorithmus, die z.B. in einem Steuergerät mittels Software auch realisiert werden kann.

Die hier vorgestellten Verfahren sowie ein entsprechendes Steuergerät können in zukünftigen Scheinwerferregelsystemen verwendet werden.

## Patentansprüche

1. Verfahren (100) zum Plausibilisieren eines Leuchtweite-Testwerts eines Lichtkegels mindestens eines Scheinwerfers (260) eines Fahrzeugs (530), **dadurch gekennzeichnet, dass** das Verfahren die folgenden Schritte aufweist:

Einlesen (110) einer Reflexionsintensität (I) eines Punktes auf mindestens einer von dem Lichtkegel beleuchteten Fahrbahnmarkierung (300; 540);
Erstellen (120) eines Reflexionsintensitätsmodells (240) für die Fahrbahnmarkierung, basierend auf der erfassten Reflexionsintensität und einer bestimmten Entfernung (x) des Punktes von dem Fahrzeug, wobei das Reflexionsintensitätsmodell ausgebildet ist, um unterschiedlichen Positionen auf der Fahrbahnmarkierung vor dem Fahrzeug unterschiedliche Reflexionsintensitäten zuzuordnen;
Bestimmen (130) eines Leuchtweite-Plausibilitätswerts ($x_1$), bei dem gemäß dem Reflexionsintensitätsmodell eine Reflexionsintensität erreicht ist, die einem Reflexionsintensitätsschwellwert (410) entspricht; und
Vergleichen (140) des Leuchtweite-Plausibilitätswerts mit dem Leuchtweite-Testwert, um den Leuchtweite-Testwert zu plausibilisieren, insbesondere um den Leuchtweite-Testwert dann zu plausibilisieren, wenn der Leuchtweite-Plausibilitätswert innerhalb eines Toleranzbereiches um den Leuchtweite-Testwert liegt.

2. Verfahren (100) gemäß Anspruch 1, **dadurch gekennzeichnet, dass** der Leuchtweite-Testwert basierend auf einer Erfassung eines in dem Lichtkegel befindlichen Objekts bestimmt wird.

3. Verfahren (100) gemäß einem der vorangegangenen Ansprüche, **dadurch gekennzeichnet, dass** in dem Schritt des Einlesens (110) die Reflexionsintensität ($I_{max}$) an dem Punkt ($x_0$) auf der Fahrbahnmarkierung (300; 540) erfasst wird, an dem die Reflexionsintensität über alle Punkte auf der Fahrbahnmarkierung maximal ist.

4. Verfahren (100) gemäß einem der vorangegangenen Ansprüche, **dadurch gekennzeichnet, dass** in dem Schritt des Einlesens (110) die Reflexionsintensität ($I, I_{max}$) eines Punktes erfasst wird, der auf der längsten aus einer Mehrzahl von vom Lichtkegel beleuchteten Fahrbahnmarkierungen (300; 540) liegt.

5. Verfahren (100) gemäß einem der vorangegangenen Ansprüche, **dadurch gekennzeichnet, dass** in dem Schritt des Bestimmens (130) ein Reflexionsintensitätsschwellwert (410) verwendet wird, der von einem in dem Fahrzeug (530) verwendeten Scheinwerfertyp abhängig ist.

6. Verfahren zur Regelung eines Gleitende-Leuchtweite-Systems (250) des Fahrzeugs (530), wobei das Verfahren die folgenden Schritte aufweist:

die Schritte (110, 120, 130, 140) gemäß einem der vorangegangenen Ansprüche, um einen plausibilisierten Leuchtweite-Testwert zu erhalten; und
Regeln des Gleitende-Leuchtweite-Systems basierend auf dem plausibilisierten Leuchtweite-Testwert.

**7.** Vorrichtung (550) zum Plausibilisieren eines Leuchtweite-Testwerts eines Lichtkegels mindestens eines Scheinwerfers (260) eines Fahrzeugs (530), wobei das die Vorrichtung (550) die folgenden Merkmale aufweist:

eine Einheit zum Erfassen (110) einer Reflexionsintensität (I) eines Punktes auf mindestens einer von dem Lichtkegel beleuchteten Fahrbahnmarkierung (300; 540);
eine Einheit zum Erstellen (120) eines Reflexionsintensitätsmodells (240) für die Fahrbahnmarkierung, basierend auf der erfassten Reflexionsintensität und einer bestimmten Entfernung (x) des Punktes von dem Fahrzeug, wobei das Reflexionsintensitätsmodell ausgebildet ist, unterschiedlichen Positionen auf der Fahrbahnmarkierung vor dem Fahrzeug unterschiedliche Reflexionsintensitäten zuzuordnen;
eine Einheit zum Bestimmen (130) eines Leuchtweite-Plausibilitätswerts ($x_1$), bei dem gemäß dem Reflexionsintensitätsmodell eine Reflexionsintensität erreicht ist, die einem Reflexionsintensitätsschwellwert (410) entspricht; und
eine Einheit zum Vergleichen (140) des Leuchtweite-Plausibilitätswerts mit dem Leuchtweite-Testwert, um den Leuchtweite-Testwert zu plausibilisieren, insbesondere um den Leuchtweite-Testwert dann zu plausibilisieren, wenn der Leuchtweite-Plausibilitätswert innerhalb eines Toleranzbereiches um den Leuchtweite-Testwert liegt.

**8.** Steuergerät (550), das ausgebildet ist, um die Schritte eines der Verfahren (100) gemäß einem der Ansprüche 1 bis 7 durchzuführen.

**9.** Computerprogrammprodukt mit Programmcode, zur Durchführung eines der Verfahren (100) nach einem der Ansprüche 1 bis 7, wenn das Programm auf einem Steuergerät (550) ausgeführt wird.

**Claims**

**1.** Method (100) for evaluating the plausibility of an illumination range test value of a light cone of at least one headlamp (260) of a vehicle (530), **characterized in that** the method has the following steps:

reading in (110) a reflection intensity (I) of a point on at least one road marking (300; 540) illuminated by the light cone;
setting up (120) a reflection intensity model (240) for the road marking, based on the detected reflection intensity and a specific distance (x) of the point from the vehicle, the reflection intensity model being designed to assign different reflection intensities to different positions on the road marking in front of the vehicle;
determining (130) an illumination range plausibility value ($x_1$) for which in accordance with the reflection intensity model a reflection intensity is reached which corresponds to a reflection intensity threshold value (410); and
comparing (140) the illumination range plausibility value with the illumination range test value in order to evaluate the plausibility of the illumination range test value, in particular in order to evaluate the plausibility of the illumination range test value whenever the illumination range plausibility value lies within a tolerance range about the illumination range test value.

**2.** Method (100) according to Claim 1, **characterized in that** the illumination range test value is determined on the basis of detection of an object located in the light cone.

**3.** Method (100) according to one of the preceding claims, **characterized in that** in the step of reading in (110) the reflection intensity ($I_{max}$) is detected at the point ($x_0$) on the road marking (300; 540) where the reflection intensity is a maximum over all the points on the road marking.

**4.** Method (100) according to one of the preceding claims, **characterized in that** the reflection intensity ($I$, $I_{max}$) of a point which lies on the longest of a plurality of road markings (300; 540) illuminated by the light cone is detected in the step of reading in (110).

**5.** Method (100) according to one of the preceding claims, **characterized in that** a reflection intensity threshold value (410) which is dependent on a type of headlamp used in the vehicle (530) is used in the step of determining (130).

**6.** Method for controlling a variable illumination range system (250) of the vehicle (530), the method having the following steps:

the steps (110, 120, 130, 140) in accordance with one of the preceding claims, in order to obtain a plausibility evaluation of an illumination range test value; and
controlling the variable illumination range system on the basis of the plausibility evaluation of the illumination range test value.

**7.** Device (550) for evaluating the plausibility of an illumination range test value of a light cone of at least one headlamp (260) of a vehicle (530), the device (550) having the following features:

a unit for detecting (110) a reflection intensity (I) of a point on at least one road marking (300; 540) illuminated by the light cone;

a unit for setting up (120) a reflection intensity model (240) for the road marking, based on the detected reflection intensity and a specific distance (x) of the point from the vehicle, the reflection intensity model being designed to assign different reflection intensities to different positions on the road marking in front of the vehicle;

a unit for determining (130) an illumination range plausibility value ($x_1$) for which in accordance with the reflection intensity model a reflection intensity is reached which corresponds to a reflection intensity threshold value (410); and

a unit for comparing (140) the illumination range plausibility value with the illumination range test value in order to evaluate the plausibility of the illumination range test value, in particular in order

to evaluate the plausibility of the illumination range test value whenever the illumination range plausibility value lies within a tolerance range about the illumination range test value.

8. Controller (550) which is designed to carry out the steps of one of the methods (100) according to one of Claims 1 to 7.

9. Computer program product with program code for carrying out one of the methods (100) according to one of Claims 1 to 7 when the program is executed on a controller (550).

**Revendications**

1. Procédé (100) de plausibilisation d'une valeur de test de portée d'éclairage du cône lumineux d'au moins un phare (260) d'un véhicule (530), **caractérisé en ce que** le procédé présente les étapes suivantes :

lecture (110) de l'intensité de réflexion (I) d'un point sur au moins un marquage (300; 540) de la chaussée éclairé par le cône lumineux,

établissement (120) d'un modèle (240) d'intensité de réflexion du marquage de la chaussée sur la base de l'intensité de réflexion saisie et de la distance (x) déterminée entre le point et le véhicule, le modèle d'intensité de réflexion étant formé pour associer différentes positions aux différentes intensités de réflexion des marquages de la chaussée situés en avant du véhicule,

détermination (130) d'une valeur ($x_1$) de plausibilité de portée d'éclairage, pour laquelle l'intensité de réflexion atteinte selon le modèle d'intensité de réflexion correspond à une valeur de seuil (410) d'intensité de réflexion et

comparaison (140) de la valeur de plausibilité de portée d'éclairage avec la valeur de test de portée d'éclairage pour plausibiliser la valeur de test de portée d'éclairage et en particulier pour plausibiliser la valeur de test de la portée d'éclairage lorsque la valeur de plausibilité de la portée d'éclairage est située à l'intérieur d'une plage de tolérance qui entoure la valeur de test de portée d'éclairage.

2. Procédé (100) selon la revendication 1, **caractérisé en ce que** la valeur de test de portée d'éclairage est déterminée en se basant sur la saisie d'un objet situé dans le cône lumineux.

3. Procédé (100) selon l'une des revendications précédentes, **caractérisé en ce que** dans l'étape de lecture (110), l'intensité de réflexion ($I_{max}$) saisie au point ($x_0$) du marquage (300; 540) est l'intensité maximale de tous les points du marquage de la chaussée.

4. Procédé (100) selon l'une des revendications précédentes, **caractérisé en ce que** l'intensité de réflexion (I, $I_{max}$) saisie à l'étape de lecture (110) est celle d'un point situé sur le plus long des marquages (300; 540) de la chaussée éclairé par le cône lumineux.

5. Procédé (100) selon l'une des revendications précédentes, **caractérisé en ce que** la valeur de seuil (410) de l'intensité de réflexion utilisée à l'étape de détermination (130) dépend du type de phare utilisé dans le véhicule (530).

6. Procédé de régulation d'un système glissant (250) de portée de lumière du véhicule (530), le procédé comportant les étapes suivantes :

les étapes (110, 120, 130, 140) selon l'une des revendications précédentes, pour obtenir une valeur de test plausibilisée de portée d'éclairage et

la régulation du système glissant de portée d'éclairage sur la base de la valeur de test plausibilisée de portée d'éclairage.

7. Dispositif (550) de plausibilisation d'une valeur de test de portée d'éclairage d'un cône lumineux d'au moins un phare (260) d'un véhicule (530), le dispositif (550) présentant les caractéristiques suivantes :

une unité de saisie (110) d'une intensité de réflexion (I) d'un point d'au moins un marquage (300; 540) de la chaussée éclairé par le cône lumineux,

une unité de formation (120) d'un modèle (240) d'intensité de réflexion du marquage de la chaussée sur la base de l'intensité de réflexion saisie et de la distance (x) définie entre le point et le véhicule, le modèle d'intensité de réflexion étant configuré pour associer différentes positions à différentes intensités de réflexion du marquage de la chaussée situé en avant du véhicule,

une unité de détermination (130) d'une valeur $(x_1)$ de plausibilité de la portée d'éclairage pour laquelle l'intensité de réflexion atteinte selon le modèle d'intensité de réflexion correspond à une valeur de seuil (410) d'intensité de réflexion et

une unité de comparaison (140) de la valeur de plausibilité de portée d'éclairage avec une valeur de test de portée d'éclairage pour plausibiliser la valeur de test de portée d'éclairage et en particulier pour plausibiliser la valeur de test de portée d'éclairage lorsque la valeur de plausibilité de portée d'éclairage est située à l'intérieur d'une plage de tolérance qui entoure la valeur de test de portée d'éclairage.

8. Appareil de commande (550) configuré pour mettre en oeuvre les étapes d'un des procédés (100) selon l'une des revendications 1 à 7.

9. Produit de programme informatique doté de codes de programme permettant la mise en oeuvre d'un procédé (100) selon l'une des revendications 1 à 7 lorsque le programme est exécuté sur un appareil de commande (550) .

**Fig. 1**

**Fig. 2**

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10311240 A1
- DE 102005033641 A1
- DE 19916175 A1